# EUROPÄISCHE PATENTSCHRIFT

(11) **EP 1 038 044 B1**
(45) Veröffentlichungstag und Bekanntmachung des Hinweises auf die Patenterteilung: **03.04.2002**
(21) Anmeldenummer: 98965743.2
(22) Anmeldetag: 03.12.1998
(51) Int. Cl.: C23C 2/00

(54) **VERFAHREN ZUM HERSTELLEN EINER BC(N):H SCHICHT**
WEAR- AND FRICTION REDUCING LAYER, SUBSTRATE WITH SUCH A LAYER AND METHOD FOR PRODUCING SUCH A LAYER
COUCHE REDUISANT L'USURE ET LE FROTTEMENT, SUBSTRAT MUNI D'UNE TELLE COUCHE ET PROCEDE POUR PRODUIRE UNE COUCHE DE CE TYPE

(30) Priorität: 03.12.1997 DE 19753624
(43) Veröffentlichungstag der Anmeldung: 27.09.2000
(73) Patentinhaber: Fraunhofer-Gesellschaft zur Förderung der angewandten Forschung e.V., 80636 München (DE)
(72) Erfinder: ECKARDT, Tanja, D-38108 Braunschweig (DE); BEWILOGUA, Klaus, D-38110 Braunschweig (DE)
(74) Vertreter: Einsel, Martin, Dipl.-Phys.
(86) Internationale Anmeldenummer: EP9807844
(87) Internationale Veröffentlichungsnummer: WO9928519

(56) Entgegenhaltungen:
- EP-A- 0 260 718
- WO-A-96/35820
- US-A- 4 594 294
- PATENT ABSTRACTS OF JAPAN vol. 003, no. 043 (C-042), 13. April 1979 & JP 54 015481 A (SEIKO EPSON CORP), 5. Februar 1979
- ONATE J I ET AL: "Deposition of hydrogenated B-C thin films and their mechanical and chemical characterization" 18TH INTERNATIONAL CONFERENCE ON METALLURGICAL COATINGS AND THIN FILMS, SAN DIEGO, CA, USA, 22-26 APRIL 1991, Bd. 49, Nr. 1-3, Seiten 548-553, XP002100463 ISSN 0257-8972, Surface and Coatings Technology, 10 Dec. 1991, Switzerland in der Anmeldung erwähnt
- PATENT ABSTRACTS OF JAPAN vol. 012, no. 254 (E-634), 16. Juli 1988 & JP 63 040318 A (FUJITSU LTD), 20. Februar 1988

## Beschreibung

Die Erfindung betrifft eine verschleiß- und reibungsmindernde Borcarbidschicht, die auf einem Substrat haftfest abgeschiedenen ist , sowie ein Verfahren zum Herstellen einer solchen verschleiß- und reibungsmindernden Schicht.

Bekannt sind Kohlenwasserstoffschichten als anorganische Verbindungen, wobei diese als Plasma- Polymerschicht mit amorphem Charakter gebildet sind. Solche Kohlenwasserstoffschichten können auch bordotiert sein. Borcarbid wird beispielsweise in Pulverform als Schleifmittel verwendet oder aber in gepresster und gesinterter Form in der Nukleartechnik für Neutronenabsorber, als Verschleißschutz für beispielsweise Sandstrahldüsen oder aber als Fadenführer in der Textilindustrie. Reines Borcarbid ist dabei ein spröder Werkstoff. Er wird daher in Form des losen Kornes zum Schleifen verwendet.

Bekannt ist es auch, eine optische, nämlich transparente Schicht herzustellen, welche beispielsweise auf der Verbindung B₂H₆ beruht, wobei der Wasserstoffanteil sehr groß ist. Der Wasserstoffanteil liegt hier bereits im Rohstoff vor.

Die EP 0 260 718 beschreibt eine Membran für eine Röntgenstrahlmaske aus Borcarbid, die durch Zusatz von Stickstoff ausreichende Steifigkeit und die erforderliche Transparenz für Röntgenstrahlen aufweisen soll."

Beispielsweise aus der US 4,716,083 ist es bekannt, Verschleißschutzschichten aus Bor und Kohlenstoff auf Bauteilen und Werkzeugen vorzusehen. In dieser Schrift ist auch ein Verfahren zur Herstellung solcher Schichten beschrieben, welche als ungeordnete Beschichtung mit einer Zusammensetzung BₓC₁₋ₓ beschrieben sind, wobei x im Bereich von 0,6 bis 0,9 liegt. Die Herstellung dieser Schichten erfolgt zum Beispiel durch Sputterverfahren, ist jedoch auch mit anderen Verfahren durchführbar. Aus der US 4,594,294 sowie der EP 0 179 582 sind Mehrlagenbeschichtungen bekannt, welche eine verschleißfeste äußere Schicht aus Bor und Kohlenstoff umfassen. Es wird dabei eine Borcarbidbeschichtung mit harter Zwischenschicht aus Carbiden, Boriden oder Nitriden auf Werkzeugen oder Maschinenelementen vorgesehen. Ebenso ist es bekannt, auf Formwerkzeugen Borcarbidbeschichtungen vorzusehen (US 4,590,031; EP 0 136 162). Auch auf Dentalwerkzeugen werden ungeordnete verschleißfeste äußere Borcarbidbeschichtungen vorgesehen (US 4,708,653). Ebenso ist es bekannt, eine Borcarbidmatrix mit dispergiertem kubischem Bomitrid als Beschichtung vorzusehen. Die Beschichtung wird durch reaktives Sputtem aufgebracht. Sie weist erste, zweite und dritte Bereiche auf. Der erste Bereich wird durch Sputtem in einer inerten Atmosphäre auf einem Substrat vorgesehen als zumindest eine Schicht aus ungeordnetem Bor und Kohlenstoff. Die inerte Sputteratmosphäre wird durch Stickstoff ersetzt, um den zweiten Bereich zu bilden, welcher Kubisch-Bornitrid-Kristalle in einer sich vergrößernden Konzentration, dispergiert in einer Matrix von ungeordnetem Bor und Kohlenstoff aufweist. Der dritte Bereich, welcher auf dem zweiten Bereich vorgesehen ist, ist als äußere Verschleißschutzschicht gebildet, welche eine im wesentlichen einheitliche Konzentration aus kubischem Bornitrid enthält, welches in ungeordnetem Bor und Kohlenstoff dispergiert ist. Eine solche Beschichtung geht aus der WO 96/35820 hervor. Die US 5,670,252 offenbart eine mehrschichtige Beschichtung, welche Bor enthält. Die Mehrschichtstruktur aus B/B₄C, kubisch Bornitrid/B₄C, Bor/kubisch Bornitrid/B₄C wird durch reaktives Sputtem hergestellt. Die Mehrschichtstruktur enthält zumindest zwei Materialien aus den genannten Gruppen (Bor, kubisch Bomitrid und Borcabid). Als Reaktivgas wird Stickstoff verwendet.

In der DE-A- 3 347 179 wird ein magnetisches Aufzeichnungsmaterial beschrieben, das eine Bor-, Kohlenstoff- und wasserstoffhattige Deckschicht zur Verbesserung der Lauf- und Abnutzungsbeständigkeit, der Härte sowie der Korrosionsbeständigkeit aufweist.

Damit die Deckschicht des magnetischen Aufzeichnungsmaterials den Magnetkopf nicht beschädigt bzw. um eine Verschlechterung der Laufeigenschaften des in Bandform vorliegenden Aufzeichnungsmaterials zu vermeiden, wird vorgeschlagen, dass der Borgehalt 50 Atomprozent nicht übersteigen sollte. Als besonders günstig werden Borgehalte in einem Bereich von 1 bis 40 Atomprozent angegeben.

Die in dieser Schrift beschriebenen Deckschichten weisen eine Dicke von 2 bis 100 nm auf, da sich bei größeren Dicken die Wiedergabeleistung bzw. -qualität verschlechtert.

Der Erfindung liegt die Aufgabe zugrunde, eine verschleiß- und reibungmindernde Schicht sowie ein Verfahren zu deren Herstellung zu schaffen, welche nicht der Gefahr unterliegt, aufgrund ihrer Sprödigkeit aufeinander reibende Oberflächen von zwei Bauteilen zu beschädigen und zugleich hart genug ist, um als Verschleißschutzschicht optimal dienen zu können.

Die Aufgabe wird mit einer auf einem Substrat haftfest abgeschiedenen, verschleiß- und reibungsmindernden Borcarbidschicht dadurch gelöst, dass die Borcarbidschicht die Elemente Bor, Kohlenstoff und Wasserstoff enthält. Durch ein Verfahren zum Herstellen einer verschleiß- und reibungsmindemden Schicht wird die Aufgabe dadurch gelöst, dass die Schicht in einem Gas- oder Dampfphasenabscheideverfahren unter Zuführung eines Prozessgases abgeschieden wird, wobei das Prozessgas oder Reaktivgas Wasserstoff enthält. Durch ein Substrat mit einer solchen Schicht wird sie dadurch gelöst, dass die Schicht eine verschleiß- und reibungsmindemde, wasserstoff-modifizierte Borcabidschicht ist. Weiterbildungen der Erfindung sind in den jeweiligen Unteransprüchen definiert.

Gemäß einer bevorzugten Ausführungsform kann die Schicht als zusätzliches Element Stickstoff enthalten. Für diesen Fall ist der Kohlenstoffgehalt entweder weniger als 1at.-% oder mehr als 10,9 at-%.

Dadurch wird vorteilhaft eine verschleiß- und reibungsmindemde Schicht geschaffen, welche zwar weniger hart als Diamant und kubisch Bomitrid ist, jedoch sehr viel kostengünstiger hergestellt werden kann, als beispielsweise Diamanten. Zudem ist die Schicht vorteilhaft härter als amorphe metallhaltige Kohlenwasserstoffschichten. Dadurch kann sie besser als Verschleißschutzschicht dienen. Aufgrund der weiteren chemischen Bindung mit Wasserstoff und evtl. Stickstoff entsteht eine Strukturmodifikation des vorzugsweise als Target dienenden elementaren Bors, stöchiometrischen oder nicht- stöchiometrischen Borcarbids, was zu einem elastischen Verhalten führt. Im Unterschied zu reinem Borcarbid ist die erfindungsgemäße Schicht nicht spröde, sondern vielmehr elastisch und zugleich hart. Im Unterschied zum Stand der Technik des heterogenen, mehrphasigen, bordotierten Kohlenwasserstoffes ist die erfindungsgemäße Schicht ein Kompaktwerkstoff, also ein homogener und einphasiger Werkstoff. Die anorganische Verbindung erscheint amorph oder kristallin. Aufgrund des elastischen Verhaltens der erfindungsgemäßen Schicht tritt vorteilhaft nicht das Problem des Standes der Technik von spröden Borcabidschichten auf, bei denen aus der Schicht heraus einzelne Partikel herausbrechen und bei aufeinanderreibenden Oberflächen die jeweiligen Bauteile im Bereich ihrer Oberfläche zerstören können. Die abrasiven Partikel können bei der erfindungsgemäßen Schicht nicht mehr herausbrechen. Dieser Vorteil ergibt sich durch den erfindungsgemäßen Zusatz von Wasserstoffanteilen, wodurch das elastische Werkstoffverhalten entsteht. Eine solche Sprödigkeit bei reinen Borcabidschichten kann auch bei Bor-Kohlenstoffschichten auftreten, wobei auch dabei ein Versagen der beschichteten Bauteile durch Abplatzen oder Ausbrechen der Schicht befürchtet werden muss. Dies wird erfindungsgemäß vorteilhaft vermieden. Die sehr hohe Härte von Borcarbid bleibt bei der erfindungsgemäßen Schicht erhalten und wird, wie bereits erwähnt, durch den Einbau geringer Mengen von Wasserstoff und/oder Stickstoff hinsichtlich seiner elastischen Eigenschaften verbessert. Dadurch weist der erfindungsgemäße Werkstoff auch einen deutlich geringeren Reibwert auf, als beispielsweise reines Borcarbid.

Die erfindungsgemäße Schicht hat einen Borgehalt von mehr als 50 at. - % bis 90 at. - %. Die Schicht weist vorzugsweise eine Zusammensetzung BₓC_{y}HᵤN_{w} auf. Besonders bevorzugt liegt der Verhältniswert y/x bei 0,4 ≥ y/x ≥ 0,1, der von w/x bei 1 > w/x ≥ 0 und der von z/y bei 1 > z/y > 0. In Zahlenwerten kann y gewählt werden zwischen 10 und 30 at.-%, z zwischen 1 und 20 at.-% und w zwischen 0 und 40 at.-%, wobei gilt, wenn w > 0 dann ist y > 10,9. Für Bor hat sich auch ein Gehalt im Bereich von 70 bis 90 at. - % bewährt.

Besonders bevorzugt wird die erfindungsgemäße Schicht durch Sputtern oder eine andere PVD-Technik (Physical Vapor Deposition Technik) hergestellt. Beim Sputtern werden sowohl Bor als auch Kohlenstoff insbesondere zerstäubt und das Reaktiv- oder Prozessgas zugeführt. Ein solcher Vorgang wird als reaktives Sputtern mit geringen Mengen an Prozessgas bezeichnet. Eine solche Technik stellt unter anderem auch das lonenplattieren, Sputtem, Gasflusssputtem oder das Arc-Verfahren dar. Zum Einstellen der Schichtzusammensetzung enthält das Prozessgas Argon (Ar), Kohlenwasserstoffe und Wasserstoff (H₂), wobei zusätzlich Stickstoff zugeführt werden kann.

Dabei wird das Bor bzw. eine borhaltige Verbindung für die vorliegende Erfindung in Form einer festen oder flüssigen Quelle bereitgestellt.

Besonders bevorzugt wird als Reaktivgas reiner Wasserstoff H₂ oder kohlenwasserstoffhaltige Gase zugeführt, wie insbesondere Methan CH₄ oder Acetylen C₂H₂. Die wasserstofftragenden Gase können mit Argon und eventuell Stickstoff einzeln oder gemischt dem Rezipienten während des Sputterprozesses als Prozessgas zugeführt werden. Der Wasserstoff unterdrückt dabei die Bildung von freiem Graphit im System Bor-Kohlenstoff und sättigt zudem freie Bindungen des Graphit ab.

Der Erfindung liegt dabei die Erkenntnis zugrunde, dass bei hydrierten Bor-Kohlenstoff-Filmen, welche im CVD-Verfahren (Chemical Vapor Deposition Verfahren) hergestellt werden, neben den Bor-Kohlenstoff-Bindungen auch Kohlenstoff-Wasserstoff- und Bor- Wasserstoff- Bindungen auftreten (Onate, J. I., Garcia, A. Bellido/*, V. Viviente, J. L., Surface and Coatings Technology 49 (1991) 548-553). Derartige metallische Bor-Kohlenstoff-Wasserstoff-Filme zeigen ein besseres elastischen Verhalten, welches auf die schwächeren Bor-Wasserstoff und Kohlenstoff-Wasserstoff-Bindungen im Vergleich zur Bor-Kohlenstoff Bindung zurückzuführen ist. Die Haftung der metallhaltigen Bor-Kohlenstoff-Wasserstoff-Filme ist gegenüber den metallhaltigen Kohlenstoff-Wasserstoff-Filmen verbessert (Lin, S.-H., Feldman, B.J., Li, D., Applied Physics Letters 69 (1996) 2373-2375). Bei derartigen CVD-Abscheidungen handelt es sich um bordotierte metallhaltige Kohlenstoffschichten, welche einen starken polymeren Charakter aufweisen, wohingegen die erfindungsgemäßen Schichten wasserstoffmodifizierte Borcarbidschichten sind.

Eine größere Flexibilität der elastischen Eigenschaften aufgrund des Einführens schwächerer Bindungen und des damit verbundenen Abbaus von Schichtspannungen bedingt auch eine bessere Haftung der erfindungsgemäßen Schichten. Eine gute Haftung einer Schicht auf einem Bauteil ist aber eine wesentliche Voraussetzung für eine verbesserte Verschleißbeständigkeit. Da bekanntlich Borcarbid auch bei höheren Temperaturen beständig ist, wird durch das erfindungsgemäße Zuführen von Wasserstoff und/oder Stickstoff eine modifizierte Borcarbidschicht geschaffen, welche nicht nur verschleiß- und reibungsmindernd, sondern auch temperaturstabil ist.

Besonders bevorzugt wird ein Magnetron-Sputtem im unbalancierten Mode vorgesehen, wobei an der Targetelektrode des Magnetrons Gleichspannung (DC) und Mittelfrequenz (MF) oder Hochfrequenz (HF) angelegt werden. Im Rahmen des Dampfphasenabscheideverfahrens wird als Prozessgas vorzugsweise CH₄ oder C₂H₂ eingebracht. Zusätzlich können auch noch Stickstoff bzw. Argon mit eingebracht werden. Dadurch ändert sich die Zusammensetzung des Endwerkstoffes. Bei der Herstellung wird Gleichspannung, Mittel- oder Hochfrequenz vorzugsweise an einer Substratelektrode angelegt, wobei die negative Spannung zum Beschießen der wachsenden Schicht mit energiereichen Ionen dient. Besonders bevorzugt liegt eine negative Spannung (=Biasspannung) von 50 bis 100 Volt an. Der im Prozess herrschende Druck wird vorzugsweise auf Werte zwischen 1 und 50µbar eingestellt. Die Biasspannung zum Sputtem, also die negative Vorspannung am Substrat, sorgt für eine kompakte und homogene Schicht. Besonders bevorzugt werden sich reibende oder gleitende und/oder bewegende Teile mit einer erfindungsgemäßen Schicht versehen. Diese Teile können Zerspanungs- oder Umformwerkzeuge sein, wie Werkzeuge zum Tiefziehen, Massivumformen, Stanzen, Schraubhalsen, Biegen etc..Sie können auch mechanisch abrasiv und/oder adhäsiv beanspruchte Komponenten sein, insbesondere aus dem Motorbereich oder der spanenden Fertigung. Gerade bei der spanenden Fertigung ist eine große Elastizität erforderlich, um Spannungen abzubauen. Der Verwendungsbereich der Schicht erstreckt sich insbesondere auf Getriebe,. Lager, Wellen, Zahnräder, Ventile, Stößel etc. Ebenfalls können Vergütungsbauteile mit einer erfindungsgemäßen Schicht versehen werden. Das modifizierte Borcarbid eignet sich vorzugsweise auch als Absorbermaterial in Kernreaktoren oder als Komponente von Hochtemperatur-Thermoelementen.

Die Schichtdicke beträgt bevorzugt 10 nm bis 100 µm, besonders bevorzugt 2 bis 10 µm.

Die Schichten sind im allgemeinen zum größten Teil amorph aufgebaut und enthalten keinen bzw. allenfalls einen geringen Anteil an mikrokristallinen, nicht kubischen Material.

Als Target wird vorzugsweise ein B₄C-Target vorgesehen, welches durch Ionenbeschuss zerstäubt wird. Dies geschieht vorzugsweise in einer Inertgasatmosphäre. Reaktivgas wird entweder zugleich zugeführt oder das Target unter Inertgas zerstäubt und das Reaktivgas in Substratnähe zugeführt.

Zur Haftverbesserung kann die Reaktiv- oder Prozessgaszusammensetzung schrittweise oder kontinuierlich geändert werden. Es entsteht eine gradierte Übergangsschicht. Es kann auch eine Haft- oder haftvermittelnde Zwischenschicht vorgesehen sein. Diese besteht insbesondere aus Metall.

Durch den Einbau von Wasserstoff wird die erfindungsgemäße Schicht stabilisiert. Um einen ausreichenden Einbau von Wasserstoff in die Schicht sicherzustellen, sollte die Substrattemperatur unter 500° C liegen.

Zur näheren Erläuterung der Erfindung werden im folgenden Ausführungsbeispiele anhand der Zeichnungen beschrieben. Diese zeigen in:
- **Figur 1**: eine perspektivische Ansicht eines mit einer erfindungsgemäßen Schicht beschichteten Werkzeuges,
- **Figur 2**: eine Schnittansicht durch ein Substrat mit erfindungsgemäßer Beschichtung und
- **Figur 3**: eine alternative Schichtausführung als Schnittansicht.

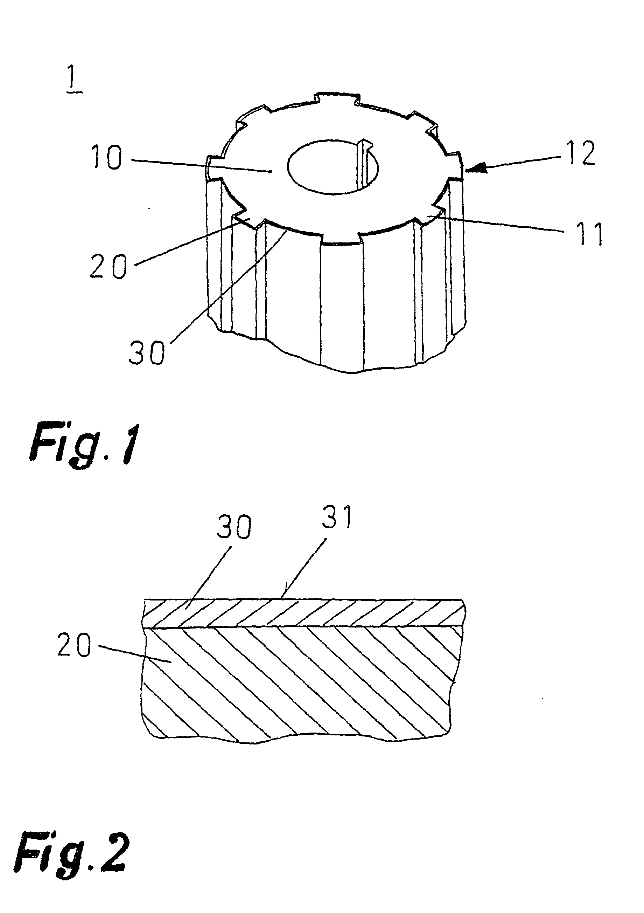

In **Figur 1** ist eine perspektivische Ansicht eines Schleifwerkzeuges 1 dargestellt. Das Schleifwerkzeug 1 weist einen Grundkörper 10 mit ringsegmentartigen Vorsprüngen 11 am äußeren Umfang 12 auf. Der Grundkörper besteht aus einem Substrat 20. Im Umfangsbereich des Grundkörpers bzw. Substrates ist dieser beschichtet. Die Beschichtung besteht in der Schicht 30, welche als homogener, einphasiger Kompaktwerkstoff eine verschleiß- und reibungsmindemde modifizierte Borcarbidschicht ist.

Auf dem Substrat 20 wird direkt die Schicht 30 aus modifiziertem Borcarbid gebildet, wie dies **Figur 2** im Schnitt als Detailansicht zeigt. Die Schichtdicke der Schicht 30 beträgt wenige µm, insbesondere 0,2 bis 10µm. Aufgrund der elastischen Eigenschaften durch Zuführen des Prozessgases Wasserstoff können an der Oberfläche 31 der Schicht 30 nicht versehentlich lose Kömer herausbrechen oder herausplatzen. Ein Schleifen ist mit einem Werkzeug mit einer solchen Schicht 30 daher gefahrlos ohne Beschädigung des zu bearbeitenden Werkstückes möglich.

Anstelle der Verwendung für ein Bauteil oder Werkzeug in Form einer Beschichtung auf dessen Oberfläche kann die erfindungsgemäße modifizierte Borcarbidschicht als Absorbermaterial in Kernreaktoren oder als Komponente von Hochtemperatur - Thermoelementen verwendet werden.

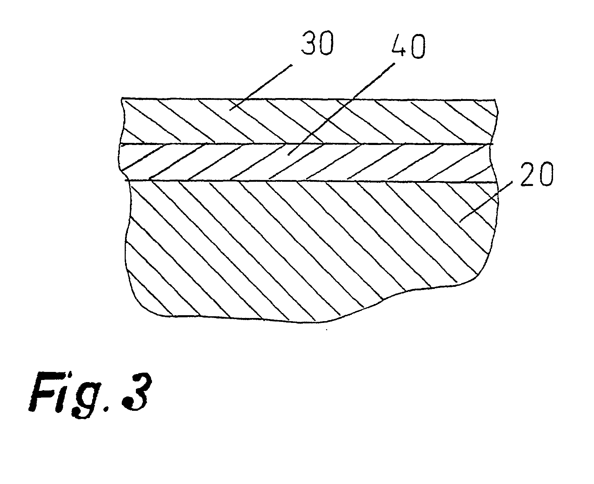

**Figur 3** zeigt eine Schnittansicht einer zweiten Ausführungsform einer erfindungsgemäßen Beschichtung. Diese weist die modifizierte Borcarbidschicht 30 auf. Zwischen Substrat 20 und Schicht 30 ist jedoch zusätzlich eine metallische Zwischenschicht 40 gebildet als haftvermittelnde Schicht. Sie besteht insbesondere aus Titan oder Chrom.

### Bezugszeichenliste

- 1: Werkzeug

- 10: Grundkörper
- 11: ringsegmentartige Vorsprünge
- 12: äußerer Umfang

- 20: Substrat

- 30: Schicht aus modifiziertem Borcarbid
- 31: Oberfläche

- 40: haftvermittelnde Zwischenschicht

## Patentansprüche

1. Verschleiß- und reibungsmindernde Borcarbidschicht, die auf einem Substrat haftfest abgeschied ist,
**dadurch gekennzeichnet,**
**dass** die Schicht die Elemente Bor, Kohlenstoff und Wasserstoff enthält, wobei der Borgehalt in einem Bereich von mehr als 50 at. - % bis 90 at. - % liegt, mit der Maßgabe, dass wenn die Schicht als zusätzliches Element Stickstoff enthält, der Kohlenstoffgehalt entweder weniger als 1 at.-% oder mehr als 10,9 at.-% ist.

2. Verschleiß- und reibungsmindemde Borcarbidschicht, die auf einem Substrat haftfest abgeschieden ist, nach Anspruch 1,
**dadurch gekennzeichnet,**
**dass** die Schicht Stickstoff enthält.

3. Verschleiß- und reibungsmindemde Borcarbidschicht, die auf einem Substrat haftfest abgeschieden ist, nach Anspruch 1 oder 2,
**dadurch gekennzeichnet,**
**dass** die Schicht eine Zusammensetzung BₓC_{y}H_{z}N_{w} aufweist.

4. Verschleiß- und reibungsmindernde Borcarbidschicht, die auf einem Substrat haftfest abgeschieden ist, nach Anspruch 3,
**dadurch gekennzeichnet,**
**dass** der Verhältniswert von y/x bei 0,4 ≥ y/x ≥ 0,1, der von w/x bei 1 > w/x ≥ 0 und der von z/y bei 1 > z/y > 0 liegt.

5. Verschleiß- und reibungsmindemde Borcarbidschicht, die auf einem Substrat haftfest abgeschieden ist, nach Anspruch 3 oder 4,
**dadurch gekennzeichnet,**
**dass** y zwischen 10 und 30 at.-%, z zwischen 1 und 20 at.-% und w zwischen 0 und 40 at.-% liegt, mit der Maßgabe, dass wenn w > 0 ist, y > 10,9 ist.

6. Verschleiß- und reibungsmindernde Borcarbidschicht, die auf einem Substrat haftfest abgeschieden ist, nach einem der vorstehenden Ansprüche,
**dadurch gekennzeichnet,**
**dass** die Schichtdicke 10 nm bis 100 nm beträgt.

7. Verschleiß- und reibungsmindernde Borcarbidschicht, die auf einem Substrat haftfest abgeschieden ist, nach einem der vorstehenden Ansprüche,
**dadurch gekennzeichnet,**
**dass** die Schichtdicke 0,2 bis 10µm beträgt.

8. Verschleiß- und reibungsmindernde Borcarbidschicht, die auf einem Substrat haftfest abgeschieden ist, nach einem der Ansprüche 1 bis 7,
**dadurch gekennzeichnet,**
**dass** die Schicht ein anorganischer, amorpher oder kristalliner homogener oder einphasiger Werkstoff ist.

9. Verschleiß- und reibungsmindernde Borcarbidschicht, die auf einem Substrat haftfest abgeschieden ist, nach Anspruch 8,
**dadurch gekennzeichnet,**
**dass** das Substrat Teil von sich bewegenden und/oder reibenden oder gleitenden Teilen ist.

10. Verschleiß- und reibungsmindemde Borcarbidschicht, die auf einem Substrat haftfest abgeschieden ist, nach Anspruch 9,
**dadurch gekennzeichnet,**
**dass** das Substrat Teil eines Kernreaktors ist, wobei die Schicht das Absorbermaterial darstellt oder
**dass** das Substrat Teil eines Hochtemperatur-Thermoelementes ist.

11. Verschleiß- und reibungsmindernde Borcarbidschicht, die auf einem Substrat haftfest abgeschieden ist, nach Anspruch 9,
**dadurch gekennzeichnet,**
**dass** die Teile Zerspanungs- oder Umformwerkzeuge oder mechanisch abrasiv und/oder adhäsiv beanspruchte Komponenten sind, insbesondere aus dem Motorenbereich, dem Bereich der spanenden Fertigung sowie der Bauteile-Vergütung.

12. Verschleiß- und reibungsmindernde Borcarbidschicht, die auf einem Substrat haftfest abgeschieden ist, nach einem der Ansprüche 8 bis 11,
**dadurch gekennzeichnet,**
**dass** das Substrat eine haftvermittelnde Schicht oder Zwischenschicht aus insbesondere einem Metall und darüber die modifizierte Borcarbidschicht aufweist.

13. Verfahren zum Herstellen einer verschleiß- und reibungsmindernden Schicht auf einem Substrat nach einem der Ansprüche 1 bis 12,
**dadurch gekennzeichnet,**
**dass** die Schicht in einem Gas- oder Dampfphasenabscheideverfahren unter Zuführung eines Prozessgases abgeschieden wird, wobei das Prozessgas oder Reaktivgas Wasserstoff enthält und Bor, Kohlenstoff und Wasserstoff abgeschieden werden.

14. Verfahren nach Anspruch 13,
**dadurch gekennzeichnet,**
**dass** dem Prozessgas zusätzlich Stickstoff zugeführt wird.

15. Verfahren nach Anspruch 13 oder 14,
**dadurch gekennzeichnet,**
**dass** das Prozessgas Argon, Kohlenwasserstoff und Wasserstoff enthält.

16. Verfahren nach einem der Ansprüche 13 oder 15,
**dadurch gekennzeichnet,**
**dass** dem Prozessgas Methan CH₄ oder Acetylen C₂H₂, zugeführt wird.

17. Verfahren nach einer der Ansprüche 13 bis 16,
**dadurch gekennzeichnet,**
**dass** das Dampfphasenabscheideverfahren ein PVD-Verfahren (Physical-Vapor-Deposition Verfahren) ist.

18. Verfahren nach Anspruch 17,
**dadurch gekennzeichnet,**
**dass** als PVD-Verfahren das Sputtern, Gasflusssputtem, Arc-Verfahren oder lonenplattieren angewendet wird.

19. Verfahren nach Anspruch 18,
**dadurch gekennzeichnet,**
**dass** das Magnetron - Sputtern im unbalancierten Mode verwendet wird, wobei an der Targetelektrode des Magnetrons Gleichspannung DC und Mittel- oder Hochfrequenz angelegt werden.

20. Verfahren nach einem der vorstehenden Ansprüche,
**dadurch gekennzeichnet,**
**dass** reaktiv mit einer geringen Menge an Reaktivgas gesputtert wird.

21. Verfahren nach einem der Ansprüche 13 bis 20,
**dadurch gekennzeichnet,**
**dass** elementares Bor oder stöchiometrisches Borcarbid oder nicht-stöchiometrisches Borcarbid oder eine B₄C-Verbindung im Rezipienten auf einem Target aufgebracht und mit dem Reaktivgas zur Reaktion gebracht werden.

22. Verfahren nach einem der Ansprüche 13 bis 21,
**dadurch gekennzeichnet,**
**dass** Bor und Kohlenstoff in einer Inertgasatmosphäre zerstäubt werden, wobei das Reaktivgas zugeführt wird.

23. Verfahren nach Anspruch 21,
**dadurch gekennzeichnet,**
**dass** das Target unter Inertgas zerstäubt und Reaktivgas in Substratnähe zugeführt wird.

24. Verfahren nach einem der Ansprüche 13 bis 23,
**dadurch gekennzeichnet,**
**dass** die wasserstofftragenden Gase sowie Stickstoff und/oder Argon einzeln oder gemischt dem Rezipienten während des Beschichtungsverfahrens als Prozessgas zugeführt werden.

25. Verfahren nach einem der Ansprüche 13 bis 24,
**dadurch gekennzeichnet,**
**dass** als Reaktiv- oder Prozessgas Wasserstoff in Form von reinem Wasserstoff H₂ oder durch kohlenwasserstoffhaltige Gase, insbesondere Methan CH₄ oder Acetylen C₂H₂ zugeführt wird.

26. Verfahren nach einem der Ansprüche 13 bis 25,
**dadurch gekennzeichnet,**
**dass** Gleichspannung DC und Mittel- oder Hochfrequenz an einer Substratelektrode angelegt werden, wobei die negative Spannung zum Beschießen der wachsenden Schicht mit energiereichen Ionen dient.

27. Verfahren nach Anspruch 26,
**dadurch gekennzeichnet,**
**dass** die negative Spannung im Bereich von 50 bis 1000 Volt liegt.

28. Verfahren nach einem der Ansprüche 13 bis 27,
**dadurch gekennzeichnet,**
**dass** der während des Prozesses herrschende Kammerdruck auf Werte zwischen 1 und 50µbar eingestellt wird.

29. Verfahren nach einem der Ansprüche 13 bis 28,
**dadurch gekennzeichnet,**
**dass** die Prozessgaszusammensetzung schrittweise oder kontinuierlich geändert wird zum Verbessern der Haftung der Schicht auf dem Substrat und/oder Schaffen einer gradierten Übergangsschicht.

30. Verfahren nach einem der Ansprüche 13 bis 29,
**dadurch gekennzeichnet,**
**dass** die Substrattemperatur kleiner als 500°C ist.

## Claims

1. A wear- and friction reducing boron carbide layer which is deposited on a substrate in adherent manner, **characterised in that** the layer contains the elements boron, carbon and hydrogen whereby the boron content lies in a range of from more than 50 atom-% up to 90 atom-%, with the proviso, that if the layer contains nitrogen as an additional element, the carbon content is either less than 1 atom-% or more than 10.9 atom-%.

2. A wear- and friction reducing boron carbide layer which is deposited on a substrate in adherent manner in accordance with Claim 1, **characterised in that** the layer contains nitrogen.

3. A wear- and friction reducing boron carbide layer which is deposited on a substrate in adherent manner in accordance with Claim 1 or 2, **characterised in that** the layer has a composition BₓC_{y}H_{z}N_{w}.

4. A wear- and friction reducing boron carbide layer which is deposited on a substrate in adherent manner in accordance with Claim 3, **characterised in that** the ratio of y/x is given by 0.4 ≥ y/x ≥ 0.1, that of w/x by 1 > w/x ≥ 0 and that of z/y by 1 > z/y > 0.

5. A wear- and friction reducing boron carbide layer which is deposited on a substrate in adherent manner in accordance with Claim 3 or 4, **characterised in that** y lies between 10 and 30 atom-%, z between 1 and 20 a% and w between 0 and 40 a%, with the proviso that if w > 0, then y > 10.9.

6. A wear- and friction reducing boron carbide layer which is deposited on a substrate in adherent manner in accordance with any of the preceding Claims, **characterised in that** the thickness of the layer is between 10 nm and 100 nm.

7. A wear- and friction reducing boron carbide layer which is deposited on a substrate in adherent manner in accordance with any of the preceding Claims, **characterised in that** the thickness of the layer is between 0.2 and 10 µm.

8. A wear- and friction reducing boron carbide layer which is deposited on a substrate in adherent manner in accordance with any of the Claims 1 to 7, **characterised in that** the layer is an inorganic, amorphous or crystalline homogeneous or single phase material.

9. A wear- and friction reducing boron carbide layer which is deposited on a substrate in adherent manner in accordance with Claim 8, **characterised in that** the substrate is a part of a plurality of relatively moving and/or mutually rubbing or sliding parts.

10. A wear- and friction reducing boron carbide layer which is deposited on a substrate in adherent manner in accordance with Claim 9, **characterised in that** the substrate is a part of a nuclear reactor wherein the layer represents the absorption material or the substrate is a part of a high temperature thermo-element.

11. A wear- and friction reducing boron carbide layer which is deposited on a substrate in adherent manner in accordance with Claim 9, **characterised in that** the parts are machining or forming tools or components subject to mechanical abrasion and/or adhesively stressed components, especially those used in engines, or in the manufacturing fields of metal cutting and component hardening and tempering.

12. A wear- and friction reducing boron carbide layer which is deposited on a substrate in adherent manner in accordance with any of the Claims 8 to 11, **characterised in that** the substrate comprises an adherency-aiding layer or intermediate layer, especially one of metal, with the modified boron carbide layer located thereupon.

13. A method of producing a wear- and friction reducing layer on a substrate in accordance with any of the Claims 1 to 12, **characterised in that** the layer is deposited in a gas or vapour phase deposition process during which a process gas is fed-in, wherein the process gas or reactive gas contains hydrogen, and wherein boron, carbon and hydrogen are deposited.

14. A method in accordance with Claim 13, **characterised in that** nitrogen is additionally added to the process gas.

15. A method in accordance with Claim 13 or 14, **characterised in that** the process gas contains argon, a hydrocarbon and hydrogen.

16. A method in accordance with either of the Claims 13 and 15 **characterised in that** methane CH₄ or acetylene C₂H₂ is added to the process gas.

17. A method in accordance with any of the Claims 13 to 16 **characterised in that** the vapour phase deposition process is a PVD process (Physical Vapour Deposition process).

18. A method in accordance with Claim 17 **characterised in that** the PVD process takes the form of a sputtering, gas flow sputtering, arcing or ion plating process.

19. A method in accordance with Claim 18 **characterised in that** the magnetron-sputtering process is used in the unbalanced mode, whereby a direct voltage DC and mid or high frequencies are applied to the target electrode of the magnetron.

20. A method in accordance with any of the preceding Claims **characterised in that** sputtering occurs reactively using a small quantity of reactive gas.

21. A method in accordance with any of the Claims 13 to 20 **characterised in that** elementary boron or stoichiometric boron carbide or non-stoichiometric boron carbide or a B₄C compound are placed in the recipient on a target and are reacted with the reactive gas.

22. A method in accordance with any of the Claims 13 to 21 **characterised in that** the boron and carbon are atomized in an inert gas atmosphere, whereby the reactive gas is fed-in.

23. A method in accordance with Claim 21 **characterised in that** the target is atomized in the presence of an inert gas and the reactive gas is fed-in close to the substrate.

24. A method in accordance with any of the Claims 13 to 23 **characterised in that** the hydrogen-bearing gases and the nitrogen and/or argon forming the process gas are supplied either alone or as a mixture to the recipient during the coating process.

25. A method in accordance with any of the Claims 13 to 24 **characterised in that** hydrogen in the form of pure hydrogen H₂ or as hydrocarbon-containing gases, especially methane CH₄ or acetylene C₂H₂, is supplied as the reactive or process gas.

26. A method in accordance with any of the Claims 13 to 25 **characterised in that** a direct voltage DC and mid or high frequencies are applied to a substrate electrode, whereby the negative voltage serves for bombarding the growing layer with high energy ions.

27. A method in accordance with Claim 26 **characterised in that** the negative voltage lies in a range of from 50 to 1000 Volts.

28. A method in accordance with any of the Claims 13 to 27 **characterised in that** the pressure prevailing in the chamber during the process is set to values of between 1 and 50 µbar.

29. A method in accordance with any of the Claims 13 to 28 **characterised in that** the composition of the process gas is continuously varied or is varied step-by-step so as to improve the adhesion of the layer to the substrate and/or to create a graduated transition layer.

30. A method in accordance with any of the Claims 13 to 29 **characterised in that** the substrate temperature is less than 500 °C.

## Revendications

1. Couche de carbure de bore diminuant l'usure et le frottement et déposée de manière adhérente sur un substrat, **caractérisée en ce que** la couche contient les éléments bore, carbone et hydrogène, la teneur en bore se situant dans une plage allant de plus de 50% atomiques à 90% atomiques, à la condition que, lorsque la couche contient comme élément supplémentaire de l'azote, la teneur en carbone est soit inférieure à 1% atomiques, soit supérieure à 10,9% atomiques.

2. Couche de carbure de bore diminuant l'usure et le frottement et déposée de manière adhérente sur un substrat selon la revendication 1, **caractérisée en ce que** la couche contient de l'azote.

3. Couche de carbure de bore diminuant l'usure et le frottement et déposée de manière adhérente sur un substrat selon la revendication 1 ou la revendication 2, **caractérisée en ce que** la couche présente une composition BₓC_{y}H_{z}N_{w}.

4. Couche de carbure de bore diminuant l'usure et le frottement et déposée de manière adhérente sur un substrat selon la revendication 3, **caractérisée en ce que** le ratio y/x se situe dans la plage de 0,4 ≥ y/x ≥ 0,1, le ratio w/x dans la plage de 1 > w/x ≥ 0 et le ratio z/y dans la plage de 1 > z/y > 0.

5. Couche de carbure de bore diminuant l'usure et le frottement et déposée de manière adhérente sur un substrat selon la revendication 3 ou la revendication 4, **caractérisée en ce que** y se situe dans la plage de 10 à 30% atomiques, z dans la plage de 1 à 20% atomiques et w dans la plage de 0 à 40% atomiques, à la condition que, lorsque w est > 0, y est > 10,9.

6. Couche de carbure de bore diminuant l'usure et le frottement et déposée de manière adhérente sur un substrat selon l'une des revendications précédentes, **caractérisée en ce que** l'épaisseur de la couche est de 10 nm à 100 nm.

7. Couche de carbure de bore diminuant l'usure et le frottement et déposée de manière adhérente sur un substrat selon l'une des revendications précédentes, **caractérisée en ce que** l'épaisseur de la couche est de 0,2 à 10 µm.

8. Couche de carbure de bore diminuant l'usure et le frottement et déposée de manière adhérente sur un substrat selon l'une des revendications 1 à 7, **caractérisée en ce que** la couche est un matériau homogène ou monophasique inorganique, amorphe ou cristallin.

9. Couche de carbure de bore diminuant l'usure et le frottement et déposée de manière adhérente sur un substrat selon la revendication 8, **caractérisée en ce que** le substrat est une partie de pièces qui se déplacent et/ou qui frottent ou glissent.

10. Couche de carbure de bore diminuant l'usure et le frottement et déposée de manière adhérente sur un substrat selon la revendication 9, **caractérisée en ce que** le substrat est une partie d'un réacteur nucléaire, la couche constituant le matériau absorbant, ou **en ce que** le substrat est une partie d'un élément thermique à haute température.

11. Couche de carbure de bore diminuant l'usure et le frottement et déposée de manière adhérente sur un substrat selon la revendication 9, **caractérisée en ce que** les pièces sont des outils d'usinage par enlèvement de matière ou de formage ou des composants sollicités par abrasion mécanique et/ou adhésion, en particulier dans le domaine des moteurs, dans le domaine de l'usinage par enlèvement de matière ainsi que dans le traitement de pièces par trempe et revenu.

12. Couche de carbure de bore diminuant l'usure et le frottement et déposée de manière adhérente sur un substrat selon l'une des revendications 8 à 11, **caractérisée en ce que** le substrat présente une couche favorisant l'adhérence ou couche intermédiaire, en particulier une couche en métal, et, sur celle-ci, la couche de carbure de bore modifié.

13. Procédé de production d'une couche diminuant l'usure et le frottement sur un substrat selon l'une des revendications 1 à 12, **caractérisé en ce que** la couche est déposée selon un procédé de dépôt en phase gazeuse ou en phase vapeur avec apport d'un gaz de procédé, dans lequel le gaz de procédé ou gaz réactif contient de l'hydrogène et du bore, du carbone et de l'hydrogène sont déposés.

14. Procédé selon la revendication 13, **caractérisé en ce que** l'on ajoute en plus de l'azote au gaz de procédé.

15. Procédé selon la revendication 13 ou la revendication 14, **caractérisé en ce que** le gaz de procédé contient de l'argon, du carbure d'hydrogène et de l'hydrogène.

16. Procédé selon l'une des revendications 13 ou 15, **caractérisé en ce que** l'on ajoute au gaz de procédé du méthane CH₄ ou de l'acétylène C₂H₂.

17. Procédé selon l'une des revendications 13 à 16, **caractérisé en ce que** le procédé de dépôt en phase vapeur est un procédé PVD (Physical Vapor Deposition).

18. Procédé selon la revendication 17, **caractérisé en ce que** l'on utilise comme procédé PVD la pulvérisation cathodique, la pulvérisation cathodique sous flux de gaz, le procédé de dépôt par décharge à arc électrique ou le dépôt par faisceau ionique.

19. Procédé selon la revendication 18, **caractérisé en ce que** l'on utilise la pulvérisation cathodique par magnétron en mode non équilibré, dans laquelle une tension continue et une fréquence moyenne ou élevée sont appliquées à l'électrode cible du magnétron.

20. Procédé selon l'une des revendications précédentes, **caractérisé en ce que** la pulvérisation cathodique s'effectue en conditions réactives avec une quantité minime de gaz réactif.

21. Procédé selon l'une des revendications 13 à 20, **caractérisé en ce que** l'on dépose du bore élémentaire ou du carbure de bore stoechiométrique ou non stoechiométrique ou un composé B₄C dans le récipient sur une cible et on le fait réagir avec le gaz réactif.

22. Procédé selon l'une des revendications 13 à 21, **caractérisé en ce que** du bore et du carbone sont pulvérisés dans une atmosphère de gaz inerte avec apport de gaz réactif.

23. Procédé selon la revendication 21, **caractérisé en ce que** la cible est pulvérisée sous un gaz inerte et le gaz réactif est amené au voisinage du substrat.

24. Procédé selon l'une des revendications 13 à 23, **caractérisé en ce que** les gaz porteurs d'hydrogène ainsi que de l'azote et/ou de l'argon sont amenés en tant que gaz de procédé, soit seuls, soit en mélange, au récipient pendant le processus de revêtement.

25. Procédé selon l'une des revendications 13 à 24, **caractérisé en ce que** l'on introduit comme gaz réactif ou gaz de procédé de l'hydrogène sous forme d'hydrogène pur H₂ ou par l'intermédiaire de gaz contenant des hydrocarbures, en particulier du méthane CH₄ ou de l'acétylène C₂H₂.

26. Procédé selon l'une des revendications 13 à 25, **caractérisé en ce que** l'on applique une tension continue et une fréquence moyenne ou élevée à une électrode de substrat, la tension négative servant à bombarder la couche en cours de croissance avec des ions à grande énergie.

27. Procédé selon la revendication 26, **caractérisé en ce que** la tension négative se situe dans la plage de 50 à 1000 volts.

28. Procédé selon l'une des revendications 13 à 27, **caractérisé en ce que** la pression qui règne dans la chambre pendant le processus est ajustée à des valeurs dans la plage de 1 à 50 µbar.

29. Procédé selon l'une des revendications 13 à 28, **caractérisé en ce que** la composition du gaz de procédé est modifiée par paliers ou en continu afin d'améliorer l'adhérence de la couche sur le substrat et/ou créer une couche de transition graduelle.

30. Procédé selon l'une des revendications 13 à 29, **caractérisé en ce que** la température du substrat est inférieure à 500°C.
